# EUROPEAN PATENT APPLICATION

(11) **EP 4 215 508 A1**
(43) Date of publication of application: **26.07.2023**
(21) Application number: 22152962.1
(22) Date of filing: 24.01.2022
(51) Int. Cl.: C04B 37/02

(54) **SUBSTRATE AND METHOD FOR PRODUCING A SUBSTRATE**

(71) Applicant: Infineon Technologies AG, 85579 Neubiberg (DE)
(72) Inventor: BAYER, Christoph, 97320 Albertshofen (DE)
(74) Representative: Westphal, Mussgnug & Partner, Patentanwälte mbB

(57) **Abstract**

A method comprises arranging at least one metallic layer on a dielectric insulation layer, with a connection layer arranged between each of the at least one metallic layer and the dielectric insulation layer, arranging a glass powder or glass paste on the dielectric insulation layer along at least one lateral surface of the connection layer and the at least one metallic layer such that the glass powder or glass paste entirely covers the at least one lateral surface of the connection layer and at least partly covers the respective lateral surface of the metallic layer, and heating and subsequently cooling the dielectric insulation layer, the at least one metallic layer, the at least one connection layer and the glass powder or glass paste such that each connection layer forms a permanent substance-to-substance bond between a respective on of the at least one metallic layer and the dielectric insulation layer, and the glass powder or glass paste melts and subsequently hardens, thereby forming a passivation layer entirely covering the at least one lateral surface of the connection layer and at least partly covering the respective lateral surface of the metallic layer.

## Description

### TECHNICAL FIELD

The instant disclosure relates to a substrate and a method for producing a substrate, in particular a substrate comprising a ceramic layer with at least one metallization layer attached thereto.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are each mounted, for example, on the first metallization layer by means of an electrically conductive connection layer. During the use of the power semiconductor module arrangement, high electric field strengths may be present at the edges of the metallization layers that may cause unwanted breakthroughs. Further, the edges of the metallization layers may be exposed to high mechanical stress. This may result in damages at the edges of the metallization layers, the substrate layer, and the electrically conductive connection layers, or any other layers of the arrangement, for example, which may negatively affect the function of the power semiconductor module arrangement and significantly reduce its lifetime. The function of the power semiconductor module arrangement may further be negatively affected and its lifetime may be reduced due to unwanted corrosion effects or humidity that may be present in the power semiconductor module arrangement, which may damage, e.g., the metallization layers, the substrate layer, and the electrically conductive connection layers, if it comes into direct contact with the respective layers.

There is a need for a substrate and a method for producing a substrate which is less likely to get damaged and has an increased lifetime.

### SUMMARY

A method includes arranging at least one metallic layer on a dielectric insulation layer, with a connection layer arranged between each of the at least one metallic layer and the dielectric insulation layer, arranging a glass powder or glass paste on the dielectric insulation layer along at least one lateral surface of the connection layer and the at least one metallic layer such that the glass powder or glass paste entirely covers the at least one lateral surface of the connection layer and at least partly covers the respective lateral surface of the metallic layer, and heating and subsequently cooling the dielectric insulation layer, the at least one metallic layer, the at least one connection layer and the glass powder or glass paste such that each connection layer forms a permanent substance-to-substance bond between a respective on of the at least one metallic layer and the dielectric insulation layer, and the glass powder or glass paste melts and subsequently hardens, thereby forming a passivation layer entirely covering the at least one lateral surface of the connection layer and at least partly covering the respective lateral surface of the metallic layer.

A substrate includes a dielectric insulation layer, at least one metallic layer permanently attached to the dielectric insulation layer by means of a connection layer, and a passivation layer along at least one lateral surface of the connection layer and the at least one metallic layer, wherein the passivation layer entirely covers the at least one lateral surface of the connection layer and at least partly covers the respective lateral surface of the metallic layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2, including Figures 2A to 2D, schematically illustrates a method for producing a substrate according to one example.
Figure 3 schematically illustrates a metallization layer on a dielectric insulation layer according to one example.
Figure 4 schematically illustrates a metallization layer on a dielectric insulation layer according to another example.
Figure 5 schematically illustrates a metallization layer on a dielectric insulation layer according to an even further example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

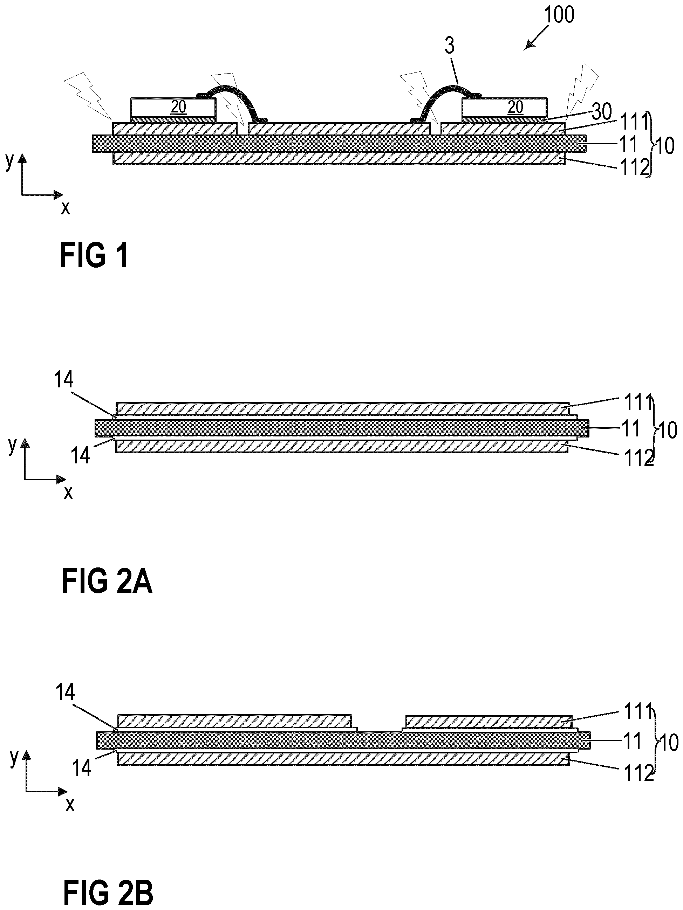

Referring to Figure 1, a cross-sectional view of a power semiconductor arrangement 100 is illustrated. The power semiconductor arrangement 100 includes a substrate 10. The substrate 10 includes a dielectric insulation layer 11, a (structured) first metallization layer (metallic layer) 111 attached to the dielectric insulation layer 11, and a (structured) second metallization layer (metallic layer) 112 attached to the dielectric insulation layer 11. The dielectric insulation layer 11 is disposed between the first and second metallization layers 111, 112. The second metallization layer 112, however, is optional and can be omitted.

Each of the first and second metallization layers 111, 112 can consist of or include one of the following materials: copper; a copper alloy; aluminum; an aluminum alloy; any other metal or alloy that remains solid during the operation of the power semiconductor arrangement. The substrate 10 can be a ceramic substrate, that is, a substrate in which the dielectric insulation layer 11 is a ceramic, e.g., a thin ceramic layer. The ceramic can consist of or include one of the following materials: aluminum oxide; aluminum nitride; zirconium oxide; silicon nitride; boron nitride; or any other dielectric ceramic. For example, the dielectric insulation layer 11 can consist of or include one of the following materials: Al₂O₃, AlN, SiC, BeO or Si₃N₄. For instance, the substrate 10 may, e.g., be an Active Metal Brazing (AMB), or a Direct Copper Bonding (DCB) substrate.

The substrate 10 can be arranged in a housing (not specifically illustrated). One or more semiconductor bodies 20 can be arranged on the substrate 10. Each of the semiconductor bodies 20 arranged on the substrate 10 can include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 can form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The second metallization layer 112 can also be a structured layer or may be omitted altogether, for example. The first metallization layer 111 in this example includes three different sections. Different semiconductor bodies 20 can be mounted to the same or to different sections of the first metallization layer 111. Different sections of the first metallization layer can have no electrical connection or can be electrically connected to one or more other sections using, e.g., bonding wires 3. Electrical connections 3 can also include bonding ribbons, connection plates, connection clips, or conductor rails, for example, to name just a few examples. The one or more semiconductor bodies 20 can be electrically and mechanically connected to the substrate 10 by an electrically conductive connection layer 30. Such an electrically conductive connection layer can be a solder layer, for example.

During the use of the power semiconductor module arrangement 100, high electric field strengths may be present especially at the edges of the different sections of the first metallization layer 111 which may cause unwanted breakthroughs. This is schematically illustrated by means of the flashes in Figure 1. Further, the edges of the metallization layers 111, 112 may be exposed to high mechanical stress. The metallization layers 111, 112, therefore, may get damaged especially at their edges which may negatively affect the function of the power semiconductor module arrangement 100 and significantly reduce its lifetime.

When producing an Active Metal Brazing (AMB) substrate, a metallic layer, e.g., a metal foil, is arranged on a dielectric insulation layer with a connection layer such as, e.g., a solder layer, arranged between the metallic layer and the dielectric insulation layer. When heated, the connection layer melts and the metallic layer is soldered to the dielectric insulation layer.

A method for producing a Direct Copper Bonding (DCB) substrate generally includes arranging a metallic layer on a dielectric insulation layer, e.g., a ceramic layer. A thin oxide layer is arranged between the metallic layer and the dielectric insulation layer. When the dielectric insulation layer with the metallic layer arranged thereon is heated to above a defined threshold temperature, a metal-oxygen eutectic forms which permanently bonds the metallic layer to the dielectrically insulating layer.

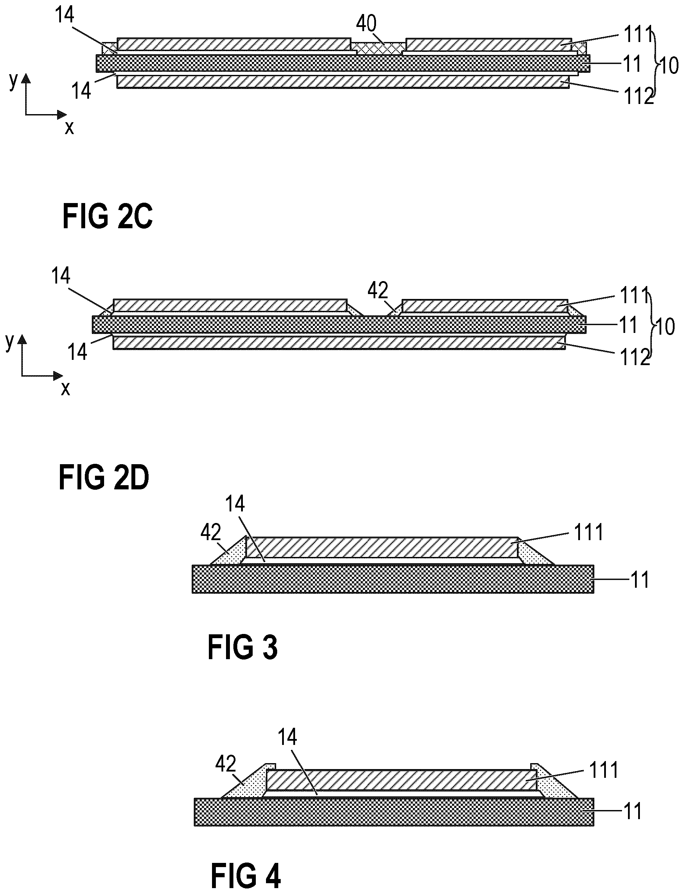

Now referring to Figure 2, a method for producing a substrate 10 according to one example is schematically illustrated. In a first step, at least one metallic layer 111, 112 is arranged on a dielectric insulation layer 11, e.g., a ceramic layer. The dielectric insulation layer 11 can comprise or consist of Al₂O₃, AlN, SiC, BeO or Si₃N₄, for example. Other materials are also possible. Each of the at least one metallic layer 111, 112 can consist of or include one of the following materials: copper; a copper alloy; aluminum; an aluminum alloy; any other metal or alloy that remains solid during the operation of the power semiconductor arrangement. In the example illustrated in Figure 2A, a first metallic layer 111 is arranged on one side of the dielectric insulation layer 11, while a second metallic layer 112 is arranged on an opposite side of the dielectric insulation layer 11. It is, however, possible to arrange one or more metallic layers 111, 112 to only one side of the dielectric insulation layer 11. For example, different sections of a metallic layer (see, e.g., first metallization layer 111 of Figure 1) may be formed on the same side of the dielectric insulation layer 11. It is, however, also possible to arrange a single metallic layer 111 on a first side of the dielectric insulation layer 11 and, in an optional step (see Figure 2B), form different sections of the metallization layer 111 by structuring the single metallic layer 111 (e.g., by means of an etching process). A connection layer 14 is arranged between each of the at least one metallic layer 111, 112 and the dielectric insulation layer 11.

The connection layer 14 can be a solder layer as is used in conventional methods for producing AMB substrates, for example. The connection layer 14 may be applied as a paste or solder preform (platelet), for example. The connection layer 14 can also be an oxide layer, for example, as is required for the production of DCB substrates. Other kinds of connection layers 14, however, are generally possible which are configured to melt at high temperatures and form a permanent connection between the at least one metallic layer 111, 112 and the dielectric insulation layer 11.

Now referring to Figure 2C, in a subsequent step, a glass powder or glass paste 40 is arranged on the dielectric insulation layer 11. The glass powder or glass paste 40 may be arranged along at least one lateral surface of the at least one connection layer 14 and the respective lateral surface of the at least one metallic layer 111 such that the glass powder or glass paste 40 entirely covers the at least one lateral surface of the connection layer 14 and at least partly covers the respective lateral surface of the metallic layer 111. A lateral surface is a surface which is essentially perpendicular to a top surface of the dielectric insulation layer 11, wherein the top surface of the dielectric insulation layer 11 is a surface on which the first metallic layer 111 is arranged.

In the example illustrated in Figure 2C, all lateral surfaces of all connection layers arranged on a first side of the dielectric insulation layer 11 are completely covered by the glass powder or glass paste 40, and all lateral surfaces of all metallic layers 111 arranged on the same side of the dielectric insulation layer 11 are partly covered by the glass powder or glass paste 40. The glass powder or glass paste 40 may comprise or consist of silicate glass or sapphire glass, for example.

Now referring to Figure 2D, the arrangement is then heated to temperatures of above the melting point of the material of the connection layer 14 and of the glass powder or glass paste 40. According to one example, the arrangement is heated to temperatures of above 1000°C, which is typically above the melting point of the material of the connection layer 14 and of the glass powder or glass paste 40. Other temperatures, however, are possible, depending on the specific melting points of the materials. When heated, the at least one connection layer 14 melts. At the same time, the glass powder or glass paste 40 melts as well. The glass powder or glass paste 40 may have the same or a similar melting point as the material that is used to form the connection layer 14. The temperature, however, may be below the melting point of the at least one metallic layer 111. The at least one metallic layer 111 may have a melting point that is higher than the melting point of the connection layer 14 and the glass powder or glass paste 40 such that the metallic layers 111 do not melt during the heating step. When the material of the connection layer 14 melts during the heating step, the glass powder or glass paste 40 arranged along at least one lateral surface of the at least one connection layer 14 prevents the material of the connection layer 14 from blurring or melting away in an uncontrolled way. Further, the at least one metallic layer 111 is prevented by the glass powder or glass paste 40 from unintentionally shifting out of place on the melted connection layer 14.

When the arrangement is subsequently cooled, the at least one metallic layer 111 is permanently attached to the dielectric insulation layer 11. The glass powder or glass paste 40 hardens and forms a passivation layer 42 entirely covering the at least one lateral surface of the connection layer 14 and at least partly covering the respective lateral surface of the metallic layer 111. The edges of the metallic layers 111, 112, therefore, may be passivated by forming the passivation layer 42 as has been described above. The edges of the metallic layers 111, therefore, are protected by the passivation layer 42 during the subsequent use of the power semiconductor module arrangement. During the heating step, some components (e.g., metals such as silver) from the connection layer 14 may diffuse into the material of the passivation layer 42 to a certain extent. This may lead to a reduction of the electric fields at the edges of the metallic layers 111 during the use of the power semiconductor module arrangement.

In the example illustrated in Figure 2 and described above, the glass powder or glass paste 40 and the resulting passivation layer 42 only partly cover the respective lateral surfaces of the metallic layer 111. As is schematically illustrated in Figure 3, however, it is also possible that the glass powder or glass paste 40 and the resulting passivation layer 42 entirely cover the respective lateral surfaces of the metallic layer 111. As is schematically illustrated in Figure 4, it is even possible that the glass powder or glass paste 40 and the resulting passivation layer 42 also partly cover a top surface of the metallic layer 111 close to its edges.

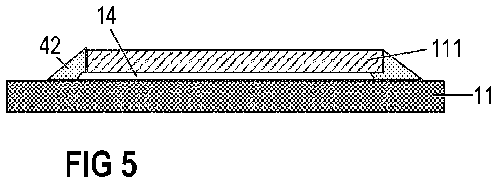

As has been mentioned above, the glass powder or glass paste 40 may prevent the material of the connection layer 14 from blurring or melting away in an uncontrolled way during the heating step. An unintentional blurring may at least be significantly reduced. However, as is schematically illustrated in Figure 5, it is still possible that the material of the connection layer 14 melts away to a certain degree. However, if this happens, any material pouring out from under the metallic layer 111 is completely covered by the resulting passivation layer 42 (see left side of metallic layer 111 in Figure 5). If this happens, cavities may form in other areas below the metallic layer 111 (see right side of metallic layer 111 in Figure 5). While such cavities can be problematic in conventional arrangements, in the arrangements disclosed herein such cavities are filled by the glass powder or glass paste 40 during the heating step. That is, the resulting passivation layer 42 may also partly be arranged in such cavities below the metallic layer 111. In this way, malfunctioning of the arrangement during its use may also be prevented.

As the glass powder or glass paste 40 may be melted during the same heating step that is performed to attach the metallic layer 111 to the dielectric insulation layer (metallic layer 111 and glass powder or glass paste 40 may be melted simultaneously), the method is very cost effective. Only one additional step of arranging the glass powder or glass paste 40 on the dielectric insulation layer 11 is required.

## Claims

1. A method comprises:
arranging at least one metallic layer (111) on a dielectric insulation layer (11), with a connection layer (14) arranged between each of the at least one metallic layer (111) and the dielectric insulation layer (11);
arranging a glass powder or glass paste (40) on the dielectric insulation layer (11) along at least one lateral surface of the connection layer (14) and the at least one metallic layer (111) such that the glass powder or glass paste (40) entirely covers the at least one lateral surface of the connection layer (14) and at least partly covers the respective lateral surface of the metallic layer (111); and
heating and subsequently cooling the dielectric insulation layer (11), the at least one metallic layer (111), the at least one connection layer (14) and the glass powder or glass paste (40) such that each connection layer (14) forms a permanent substance-to-substance bond between a respective on of the at least one metallic layer (111) and the dielectric insulation layer (11), and the glass powder or glass paste (40) melts and subsequently hardens, thereby forming a passivation layer (42) entirely covering the at least one lateral surface of the connection layer (14) and at least partly covering the respective lateral surface of the metallic layer (111).

2. The method of claim 1, wherein heating the dielectric insulation layer (11), the at least one metallic layer (111), the at least one connection layer (14) and the glass powder or glass paste (40) comprises heating the dielectric insulation layer (11), the at least one metallic layer (111), the at least one connection layer (14) and the glass powder or glass paste (40) to temperatures of above the melting point of the materials of the at least one connection layer (14) and the glass powder or glass paste (40), and below the melting point of the at least one metallic layer (111).

3. The method of claim 1 or 2, wherein the glass powder or glass paste (40) is arranged on the dielectric insulation layer (11) such that it entirely covers the respective lateral surfaces of the metallic layer (111).

4. The method of claim 3, wherein the glass powder or glass paste (40) is arranged on the dielectric insulation layer (11) such that it further partly covers a top surface of the metallic layer (111).

5. The method of any of claims 1 - 4, wherein arranging at least one metallic layer (111) on a dielectric insulation layer (11) comprises arranging a layer comprising or including copper, a copper alloy, aluminum, or an aluminum alloy on the dielectric insulation layer (11).

6. The method of any of the preceding claims, wherein arranging at least one metallic layer (111) on a dielectric insulation layer (11) comprises arranging at least one metallic layer (111) on a layer comprising or consisting of Al₂O₃, AlN, SiC, BeO or Si3N4.

7. The method of any of the preceding claims, wherein arranging a glass powder or glass paste (40) on the dielectric insulation layer (11) comprises arranging a silicate glass or sapphire glass powder or paste on the dielectric insulation layer (11).

8. A substrate (10) comprising:
a dielectric insulation layer (11);
at least one metallic layer (111) permanently attached to the dielectric insulation layer (11) by means of a connection layer (14); and
a passivation layer (42) along at least one lateral surface of the connection layer (14) and the at least one metallic layer (111), wherein
the passivation layer (42) entirely covers the at least one lateral surface of the connection layer (14) and at least partly covers the respective lateral surface of the metallic layer (111).

9. The substrate (10) of claim 8, wherein the dielectric insulation layer comprises or consists of Al₂O₃, AlN, SiC, BeO or Si₃N₄.

10. The substrate (10) of claim 8 or 9, wherein the at least one metallic layer (111) consist of or includes one of the following materials: copper; a copper alloy; aluminum; and an aluminum alloy.

11. The substrate (10) of any of claims 8 - 10, wherein the passivation layer (42) comprises or consists of silicate glass or sapphire glass.

12. The substrate (10) of any of claims 8 - 11, wherein the connection layer (14) is a solder layer or an oxide layer.

13. The substrate (10) of any of claims 8 - 12, wherein the passivation layer (42) entirely covers the respective lateral surface of the metallic layer (111).

14. The substrate (10) of any of claims 8 - 13, wherein the passivation layer (42) further partly covers a top surface of the metallic layer (111).

## Amended claims

### Amended claims in accordance with Rule 137(2) EPC.

1. A method comprises:
arranging at least one metallic layer (111) on a dielectric insulation layer (11), with a connection layer (14) arranged between each of the at least one metallic layer (111) and the dielectric insulation layer (11);
arranging a glass powder or glass paste (40) on the dielectric insulation layer (11) along at least one lateral surface of the connection layer (14) and the at least one metallic layer (111) such that the glass powder or glass paste (40) entirely covers the at least one lateral surface of the connection layer (14) and at least partly covers the respective lateral surface of the metallic layer (111); and
heating and subsequently cooling the dielectric insulation layer (11), the at least one metallic layer (111), the at least one connection layer (14) and the glass powder or glass paste (40) such that each connection layer (14) forms a permanent substance-to-substance bond between a respective on of the at least one metallic layer (111) and the dielectric insulation layer (11), and the glass powder or glass paste (40) melts and subsequently hardens, thereby forming a passivation layer (42) entirely covering the at least one lateral surface of the connection layer (14) and at least partly covering the respective lateral surface of the metallic layer (111).

2. The method of claim 1, wherein heating the dielectric insulation layer (11), the at least one metallic layer (111), the at least one connection layer (14) and the glass powder or glass paste (40) comprises heating the dielectric insulation layer (11), the at least one metallic layer (111), the at least one connection layer (14) and the glass powder or glass paste (40) to temperatures of above the melting point of the materials of the at least one connection layer (14) and the glass powder or glass paste (40), and below the melting point of the at least one metallic layer (111).

3. The method of claim 1 or 2, wherein the glass powder or glass paste (40) is arranged on the dielectric insulation layer (11) such that it entirely covers the respective lateral surfaces of the metallic layer (111).

4. The method of claim 3, wherein the glass powder or glass paste (40) is arranged on the dielectric insulation layer (11) such that it further partly covers a top surface of the metallic layer (111).

5. The method of any of claims 1 - 4, wherein arranging at least one metallic layer (111) on a dielectric insulation layer (11) comprises arranging a layer comprising or including copper, a copper alloy, aluminum, or an aluminum alloy on the dielectric insulation layer (11).

6. The method of any of the preceding claims, wherein arranging at least one metallic layer (111) on a dielectric insulation layer (11) comprises arranging at least one metallic layer (111) on a layer comprising or consisting of Al₂O₃, AlN, SiC, BeO or Si₃N₄.

7. The method of any of the preceding claims, wherein arranging a glass powder or glass paste (40) on the dielectric insulation layer (11) comprises arranging a silicate glass or sapphire glass powder or paste on the dielectric insulation layer (11).
